# EUROPÄISCHE PATENTANMELDUNG

(11) **EP 1 420 311 A1**
(43) Veröffentlichungstag der Anmeldung: **19.05.2004**
(21) Anmeldenummer: 03026035.0
(22) Anmeldetag: 12.11.2003
(51) Int. Cl.: G05B 19/418, G07C 3/14

(54) **Verfahren und Vorrichtung zur rechnergestützten Überwachung eines Prozessparameters eines Herstellungsprozesses**

(30) Priorität: 12.11.2002 DE 10252606
(71) Anmelder: Infineon Technologies AG, 81669 München (DE)
(72) Erfinder: Märitz, Jörn, 93152 Zeiler-Nittendorf (DE); Steinkirchner, Erwin, 94315 Straubing (DE)
(74) Vertreter: Viering, Jentschura & Partner

(57) **Zusammenfassung**

Bei dem Verfahren zur rechnergestützten Überwachung von Prozessparametern eines Herstellungsprozesses eines physikalischen Objektes sind Objekt-Daten, welche das physikalische Objekt kennzeichnen, verschiedenen Hierarchieebenen zugeordnet, Objekt-Daten verschiedener Hierarchieebenen sind zu hierarchischen Objekt-Datensätzen gruppiert, Grenzwerte für mindestens einen Prozessparameter sind gespeichert und jeweils einem hierarchischen Objekt-Datensatz zugeordnet, bei der Herstellung physikalischer Objekte gemessene Prozessdaten des mindestens einen Prozessparameters sind gespeichert und für hergestellte physikalische Objekte sind die den Objekt-Daten entsprechenden hierarchischen Objekt-Datensätze ermittelt. Bei dem verfahren werden ferner die für die entsprechenden Objekt-Datensätze gespeicherten Prozessdaten mit den gespeicherten Grenzwerten für die entsprechenden Objekt-Datensätze verglichen, bei dem Vergleich werden die Hierarchieebenen des Objekt-Datensatzes der gespeicherten Prozessdaten derart gemäß einer vorgebbaren Hierarchie iterativ abgearbeitet, dass ausgehend von einer höchsten Hierarchieebene solange die nächstniedrigere Hierarchieebene abgearbeitet wird, bis die Abarbeitung die niedrigste Hierarchieebene erreicht hat und es wird ein unspezifischer Wert für die Hierarchieebene hinterlegt, wenn für eine Hierarchieebene kein spezifischer Wert im Objekt-Datensatz hinterlegt wird.

## Beschreibung

Die Erfindung betrifft ein Verfahren, eine Vorrichtung, ein computerlesbares Speichermedium und ein Computerprogramm-Element zur rechnergestützten Überwachung eines Prozessparameters eines Herstellungsprozesses eines physikalischen Objekts.

Im Allgemeinen werden die Halbleiterchips zu mehreren auf so genannten Wafern hergestellt. Diese Wafer werden wiederum zu so genannten Losen zusammengefasst, in welchen eine Vielzahl von individuellen Wafern für eine weitere Behandlung der Wafer Objekt-Daten zusammengefasst werden.

Bei der Herstellung von Wafern mit hochintegrierten Halbleiterchips werden insbesondere durch die immer weiter steigende Miniaturisierung der Strukturen auf dem Halbleiterchip immer höhere Anforderungen an die für die Herstellung der Halbleiterchips verwendeten Fertigungsanlagen und Herstellungsprozesse auftreten. Die Stabilität und Reproduzierbarkeit sowohl der Fertigungsanlagen als auch der Herstellungsprozesse beeinflussen maßgeblich die Ausbeute und Produktivität im Rahmen der Halbleiterchip-Fertigung. Schon kleine Abweichungen von einem Soll-Verhalten einer Chip-Fertigungsanlage im Rahmen der Produktion können zu einer erheblichen Verschlechterung der Ausbeute, das heißt zu einer erheblichen Erhöhung der Fehlerrate bei den hergestellten Halbleiterchips führen.

Für ein Qualitätsmanagement, d.h. um die Qualität des Herstellungsprozesses und die Qualität der Wafer sicherzustellen, müssen die fertig prozessierten Wafer Testmessungen unterzogen werden. Um den Herstellungsprozess vollständig zu überwachen und zu beurteilen, wäre es für ein vollständiges und exaktes Bestimmen der Produktqualität der Wafer eines Loses an sich nötig jeden einzelnen Wafer, welcher mittels des Herstellungsverfahrens produziert wurde, zu testen und die Qualität des Wafers anschließend zu beurteilen. Dies ist jedoch aufgrund der zeit- und kostenintensiven Testmessungen zum Bestimmen der Qualität der Wafer nicht möglich.

Zum Qualitätsmanagement wird häufig das so genannte "Statistical Process Control" (SPC) Verfahren verwendet. Gemäß diesem Verfahren werden stichprobenhaft Wafer mittels Testmessungen auf ihre Qualität hin geprüft und anhand der Ergebnisse der stichprobenhaften Untersuchungen auf die Produktqualität gesamter Lose eines Herstellungsverfahrens geschlossen. Die Stichproben werden hierbei zufällig aus den Wafern eines Loses gezogen. Mittels dieses SPC-Verfahrens wird die durchschnittliche Qualität der Wafer eines Loses oder eines Herstellungsverfahrens bestimmt.

Im Qualitätsmanagement ist neben dem Bestimmen der durchschnittlichen Qualität der Wafer eines Loses auch nötig, Wafer, welche eine geringe Qualität und somit einem vorgegebenen Qualitätslimit nicht genügen, auszusondern und einer Sonderbehandlung, d.h. einer Sondermessung, einem eventuellen Nacharbeiten oder Aussortieren, zuzuführen. Hierzu müssen diejenigen Wafer eines Loses bestimmt werden, bei welchen die Gefahr besteht, dass sie dem vorgegebenen Qualitätslimit nicht genügen, weil bei ihrer Prozessierung im Herstellungsverfahren Fehler aufgetreten sind. Hierzu wird häufig das so genannte "Fault Detection and Classification" (FDC) Verfahren verwendet. Mittels dieses Verfahrens werden Prozessfehler, d.h. Fehler, welche in dem Herstellungsprozess aufgetreten sind, erfasst. Die entsprechenden Fehler werden in der Anmeldung als FDC-Fehler bezeichnet.

Auch sollte das Erkennen von Wafern, welche dem Qualitätslimit nicht genügen, möglichst früh und sicher im Herstellungsprozess vorgenommen werden, um ein eventuelles Problem in der Herstellung möglichst früh zu bemerken. Eine Möglichkeit, die Wafer, welche dem Qualitätslimit möglicherweise nicht genügen, zu bestimmen (schlechter Wafer), ist das Verwenden so genannter Prozessdaten. Diese Prozessdaten sind Werte von Prozessparametern, welche während des Herstellungsprozesses ständig aufgenommen werden. Beispiele für Prozessdaten sind z.B. der Druck oder die Temperatur in einer Prozesskammer während eines Prozessschrittes.

Gemäß dem Stand der Technik wird zum Erkennen der schlechten Wafer für jeden Prozessparameter ein oberer und/oder unterer Grenzwert oder Schwellenwert hinterlegt. Diesen Grenzwert darf der Wert des Prozessparameters (Prozessdatum) bei dem Herstellungsprozess nicht über- bzw. nicht unterschreiten. Gemäß dem Stand der Technik tritt jedoch das Problem auf, dass die Anzahl dieser Grenzwerte für eine Wafer-Produktionsanlage sehr schnell einen Wert annimmt, welcher nicht mehr verwaltbar ist, da ein Produkt, welches überwacht werden soll, mittels verschiedener Operationen, Maschinen, Rezepten usw. hergestellt werden kann. Die Operationen, Maschinen, Rezepte usw. werden im Folgenden als Hierarchieebenen bezeichnet, d.h. eine Hierarchieebene ist z.B. die Menge aller auftretender Rezepte. Somit ergibt sich als Anzahl der zu hinterlegenden Grenzwerte die Anzahl der bei der Herstellung der Wafer auftretenden Kombinationen der Hierarchieebenen, d.h. die Anzahl der produzierten Produkte multipliziert mal der Anzahl der für die Produktion benötigten Prozessschritte multipliziert mal der Anzahl der Rezepte pro Produkt multipliziert mal der Anzahl der möglichen Maschinen. Die Anzahl der zu hinterlegenden Grenzwerte beträgt in einem typischen Fall von 300 Produkten bei 20 Prozessschritten, bei 10 Rezepten pro Produkt und bei 20 möglichen Maschinen 1.200.000. Diese Anzahl ist so hoch, dass der entsprechende Satz von Grenzwerten nicht mehr verwaltbar oder pflegbar ist. Somit ist eine Überwachung dieser Grenzwerte praktisch nicht möglich.

Aus [1] Druckschrift D1 (US 2002/0055194 A1) ist Verfahren zur Qualitätsüberwachung einer Produktionslinie bekannt, bei dem ein Trend in der Qualitätscharakteristik der Produktionslinie oder Fluktuationen in einem frühen Stadium detektiert werden.

Aus [2] ist eine End-Wafer-Sortierungs-(FWS)-Testanlage bekannt, bei der Roh-Ausgabedaten, welche mittels FWS-Teststationen ausgegeben werden, um zusätzliche differenzierende Daten vermehrt werden, um dadurch differenzierbare Ausgabedaten zu erzeugen, welche gemäß einer Anzahl von Kriterien sortiert werden können.

Aus C. Schneider et al., IEEE/SEMI Advanced Semiconductor Manufacturing Conference, April 2001, Seite 33 bis 40 [3] ist eine automatische Steuerung der "Critical Dimension (CD)" in einem photolithographischen Verfahren bekannt. Hierzu wird ein System vorgestellt, welches historische Einstellungen von Produktionswerkzeugen für jede Kombination von Produkt, Retikel, Maskenschicht und Werkzeugkombination in einer Datenbank speichert.

Der Erfindung liegt das Problem zugrunde, die Überwachung von Prozessparametern eines Herstellungsverfahrens einfacher und effektiver zu gestalten.

Das Problem wird durch das Verfahren zum Überwachen von Prozessparametern für ein Herstellungsprozesses mit den Merkmalen gemäß den unabhängigen Patentansprüchen gelöst.

Bei dem Verfahren zur rechnergestützten Überwachung von Prozessparametern eines Herstellungsprozesses eines physikalischen Objektes sind Objekt-Daten, welche das physikalische Objekt kennzeichnen, verschiedenen Hierarchieebenen zugeordnet, Objekt-Daten verschiedener Hierarchieebenen sind zu hierarchischen Objekt-Datensätzen gruppiert, Grenzwerte für mindestens einen Prozessparameter sind gespeichert und jeweils einem hierarchischen Objekt-Datensatz zugeordnet, bei der Herstellung physikalischer Objekte gemessene Prozessdaten des mindestens einen Prozessparameters sind gespeichert und für hergestellte physikalische Objekte sind die den Objekt-Daten entsprechenden hierarchischen Objekt-Datensätze ermittelt. Bei dem Verfahren werden ferner die für die entsprechenden Objekt-Datensätze gespeicherten Prozessdaten mit den gespeicherten Grenzwerten für die entsprechenden Objekt-Datensätze verglichen, bei dem Vergleich werden die Hierarchieebenen des Objekt-Datensatzes der gespeicherten Prozessdaten derart gemäß einer vorgebbaren Hierarchie iterativ abgearbeitet, dass ausgehend von einer höchsten Hierarchieebene solange die nächstniedrigere Hierarchieebene abgearbeitet wird, bis die Abarbeitung die niedrigste Hierarchieebene erreicht hat und es wird ein unspezifischer Wert für die Hierarchieebene hinterlegt, wenn für eine Hierarchieebene kein spezifischer Wert im Objekt-Datensatz hinterlegt wird.

In dieser Anmeldung wird unter einer Hierarchieebene eine Hierarchieebene eines Herstellungsprozesses verstanden. Wie oben beschrieben ist gehören z.B. alle Rezepte, welche in dem Herstellungsverfahren verwendet werden, der Hierarchieebene "Rezept" an, oder alle verwendeten Maschinen, gehören der Hierarchieebene "Maschinen" an, oder alle produzierten Produkte gehören der Hierarchieebene "Produkte" an. Das einzelne Datum, welches einer Hierarchieebene zugewiesen wird, wird als Objekt-Datum bezeichnet. Z.B. ist ein Objekt-Datum das Rezept L071F, die Maschine 121 oder das Produkt SFET2.

Weiterhin wird in dieser Anmeldung unter einem Objekt-Datensatz eine Kombinationen von Objekt-Daten verschiedener Hierarchieebenen verstanden. D.h. ein Objekt-Datensatz entspricht einer möglichen Kombination der Objekt-Daten der Hierarchieebenen, welche im Herstellungsprozess eines physikalischen Objektes auftreten. Z.B. entspricht ein Objekt-Datensatz einer Kombination der Hierarchieebenen Produkt B6HFC, welches mittels Prozessschritt 2571, mittels Rezeptes L071F, mittels der Maschine 121 hergestellt wurde.

Unter einem Prozessparameter ist in diesem Zusammenhang ein Parameter eines Herstellungsprozesses eines physikalischen Objektes zu verstehen. Hierunter fallen zum Beispiel bei der Herstellung die Dejustierung, d.h. die Ungenauigkeit der Positionierung eines Wafers in einer Maschine oder anders ausgedrückt eine Abweichung einer tatsächlichen Position des Wafers in der Maschine von der Sollposition des Wafers in der Maschine, innerhalb eines Positionierungsschrittes, die Temperatur während eines Prozessschrittes, der Gasfluss während eines Prozessschrittes, die Zeitdauer eines Prozessschrittes, der während eines Prozessschrittes herrschende Druck, allgemein alle Ventilstellungen, eine Waferträger-Geschwindigkeit und ein Waferträger-Andruck. Andere Prozessparameter in einer Lithographie sind zum Beispiel verschiedene Justagegrößen, eine Fokussierung oder eine Dosis. Diese Prozessparameter werden ständig während des Herstellungsprozesses aufgenommen und stehen für eine weitere Verwendung bereit

Unter einer Hierarchieebene wird vorzugsweise eine logistische Ebene des Herstellungsprozesses verstanden. In dieser Anmeldung sind dies vorzugsweise z.B. eine Prozesseinheitenebene, d.h. ein Workcenter, eine Produktgruppenebene, d.h. eine Gruppe in der die verschiedenen hergestellten Produkte unterschieden werden, welche in einem bestimmten Workcenter hergestellt werden, eine Operationsebene, d.h. eine Ebene, in welchen die hergestellten Produkte weiter nach den Operationen unterschieden werden, mittels welchen sie hergestellt werden, eine Equipment- oder Maschinenebene, d.h. eine Ebene auf der unterschieden wird, mittels welcher Maschine eine bestimmte Operation ausgeführt wird, und eine Rezeptebene, d.h. eine Ebene in der unterschieden wird, mittels welchen Rezeptes ein Produkt auf einer bestimmten Maschine hergestellt wird.

In der Anmeldung wird zwischen spezifischen Objekt-Daten und unspezifischen Objekt-Daten unterschieden. Unter spezifischen Objekt-Daten werden z.B. das Objekt-Datum L071F für ein Rezept, 121 für eine Maschine, oder SFET2 für ein Produkt verstanden. Unter einem unspezifischen Objekt-Datum wird ein "*" verstanden. Dieses unspezifische Objekt-Datum "*" wird für eine Hierarchieebene verwendet, wenn das Objekt-Datum nicht genauer spezifiziert werden kann oder soll. Das unspezifische Objekt-Datum kann als eine Art Platzhalter verstanden werden, welcher für alle in einem Herstellungsprozess möglichen Objekt-Daten einer Hierarchieebene außer denen steht, welche für die Hierarchieebene genau spezifiziert werden.

Unter einem jedem Objekt-Datensatz wird eine spezielle in einem Herstellungsprozess auftretende Kombination von Objekt-Daten verschiedener Hierarchieebenen des Prozesses verstanden, wobei es verschiedene Objekt-Datensätzen gibt. Ein exakt spezifizierter Objekt-Datensatz ist ein Objekt-Datensatz, bei welchem für alle Hierarchieebenen ein spezifisches Objekt-Datum zugeordnet ist. Ein unspezifischer Objekt-Datensatz ist ein Objekt-Datensatz, bei welchem zumindest einer Hierarchieebene ein spezifisches Objekt-Datum und zumindest einer Hierarchieebene ein unspezifisches Objekt-Datum zugeordnet ist.

Die Vorrichtung zum rechnergestützten Überwachen von Prozessparametern eines Herstellungsprozesses eines physikalischen Objektes weist mindestens einen Prozessor auf, der so eingerichtet ist, dass die oben beschriebenen Verfahrensschritte durchgeführt werden können.

In einem computerlesbaren Speichermedium ist ein Bearbeitungsprogramm zum Überwachen von Prozessparametern eines Herstellungsprozesses eines physikalischen Objektes gespeichert, welches Bearbeitungsprogramm, wenn es von einem Prozessor ausgeführt wird, die oben beschriebenen Verfahrensschritte aufweist.

Ein Computerprogramm-Element zum Überwachen von Prozessparametern eines Herstellungsprozesses eines physikalischen Objektes, weist die oben beschriebenen Verfahrensschritte auf, wenn es von einem Prozessor ausgeführt wird.

Die Erfindung kann sowohl mittels eines Computerprogramms, d.h. einer Software, als auch mittels einer oder mehrerer spezieller elektrischer Schaltungen, d.h. in Hardware oder in beliebig hybrider Form, d.h. mittels Software-Komponenten und Hardware-Komponenten, realisiert werden.

Mittels des erfindungsgemäßen Verfahrens wird der Aufwand, eine Vielzahl von Grenzwerten für die Produktion eines physikalischen Objekts zu überwachen und zu verwalten, stark reduziert. Durch das Ausnutzen einer hierarchischen Ordnung der Hierarchieebenen ist es möglich die Anzahl der zu hinterlegenden Grenzwerte so weit zu reduzieren, dass eine Verwaltung und Pflege der Grenzwerte möglich wird und damit auch erst eine Überwachung der einzelnen Prozessparameter. Insbesondere lässt sich mittels der unspezifischen Objekt-Daten die Anzahl der zu hinterlegenden Grenzwerte drastisch reduzieren. Ein weiterer Vorteil ist es, dass mittels des Verwendens der unspezifischen Objekt-Daten auch neue oder noch nicht überwachte Produkte, d.h. Produkte für welche noch kein spezifischer Grenzwert hinterlegt wurde, überwacht werden können. Wobei unter einen spezifischen Grenzwert ein Grenzwert für einen Prozessparameter verstanden wird, welcher einem exakt spezifizierten Objekt-Datensatz, d.h. einen Objekt-Datensatz, bei welchem für keine Hierarchieebene ein unspezifisches Objekt-Datum hinterlegt ist, zugeordnet ist. Während unter einem unspezifischen Grenzwert ein Grenzwert für einen Prozessparameter verstanden wird, welcher einem nicht exakt spezifizierten Objekt-Datensatz, d.h. einen Objekt-Datensatz, bei welchem für mindestens eine Hierarchieebene ein unspezifisches Objekt-Datum hinterlegt ist, zugeordnet ist.

Bevorzugte Weiterbildungen der Erfindung ergeben sich aus den abhängigen Ansprüchen. Die weiteren Ausgestaltungen der Erfindung betreffen das Verfahren und die Vorrichtung, zum Überwachen von Prozessparametern des Herstellungsprozesses eines physikalischen Objektes, das computerlesbare Speichermedium und das Computerprogramm-Element.

Vorzugsweise ist das physikalische Objekt ein Wafer.

Insbesondere bei der Waferherstellung mit ihrer extrem hohen Zahl von Prozessschritten und damit einer extrem hohen Anzahl von für Prozessparameter zu hinterlegenden Grenzwerten mit sehr hohen Anforderungen an die Genauigkeit der Einstellung der Prozessparameter eignet sich die Erfindung gut, da in diesem Bereich somit erstmals eine Überwachung von Prozessparametern auf einfache Weise realisiert ist. Es besteht erstmals die Möglichkeit eine Überwachung durchzuführen, da mittels der Erfindung die Zahl der zu hinterlegenden Grenzwerte so verringert wird, dass eine Verwaltung und Pflege dieser Grenzwerte möglich wird.

Bei einer Weiterbildung des Verfahrens entsprechen die Hierarchieebenen logistischen Ebenen des Herstellungsprozesses.

Gemäß einer Ausgestaltung des Verfahrens werden unspezifische Grenzwerte für Prozessparameter hinterlegt, indem unspezifische Objekt-Daten verwendet werden.

Mittels des Verwendens von unspezifischen Objekt-Daten ist es möglich so genannte unspezifische Grenzwerte für einen Prozessparameter zu hinterlegen. Diese unspezifischen Grenzwerte sind nicht für einen exakt spezifizierten Objekt-Datensatz gültig, d.h. für einen Objekt-Datensatz, in welchem für jede Hierarchieebene ein spezifisches Objekt-Datum hinterlegt wird, sondern für Objekt-Datensätze, für welche kein spezifischer Grenzwert hinterlegt wird. Es ist also z.B. möglich, einen unspezifischen Grenzwert eines Prozessparameters für ein Produkt zu hinterlegen, welcher unspezifische Grenzwert dann unabhängig von den Objekt-Daten einzelner Hierarchieebenen des Objekt-Datensatzes gültig ist, solange nicht für den Objekt-Datensatz ein spezifischer Grenzwert hinterlegt wird. Mittels der unspezifischen Grenzwerte können auch neue oder noch nicht gepflegte Produkte oder neue Herstellungsverfahren, d.h. neue Prozessschritte für ein Produkt, überwacht werden.

Vorzugsweise werden die Werte des mindestens einen Prozessparameters gemessen.

Bei dem erfindungsgemäßen Verfahren können die Hierarchieebenen gemäß der vorgebbaren Hierarchie sortiert werden.

Anschaulich kann man sich die erfindungsgemäße Verwaltung von Grenzwerten in Tabellenform vorstellen. Zum Verwalten der Grenzwerte für Prozessparameter eines Objekt-Datensatzes bei der Herstellung eines physikalischen Objekts wird ein hierarchische Verwaltungsverfahren geschaffen. In Tabellenform wird hierbei für jedem Objekt-Datensatz einem Prozessparameter ein Grenzwert zugewiesen, wobei die Hierarchieebenen auch mit unspezifischen Objekt-Daten verknüpft werden können. Diese unspezifischen Objekt-Daten bedeuten, dass an der Stelle, an welcher unspezifische Objekt-Datum steht, alle möglichen Werte eingesetzt werden können, außer den Werten, welche für die betreffende Hierarchieebene genauer spezifiziert sind. D.h. ein Grenzwert eines Prozessparameters für einen Objekt-Datensatz kann für Prozessparameter physikalischer Objekte, welche unterschiedliche Objekt-Daten aufweisen, gültig sein. Dies reduziert den Verwaltungs- und Pflegeaufwand für die Grenzwerte enorm. Ferner ist auch die Überwachung neuer oder noch nicht gepflegter Produkte möglich.

Mittels bevorzugter Ausgestaltungen der Erfindung ist es möglich, den Aufwand beim Verwalten einer Vielzahl von Grenzwerten zu verringern. Es wird ein hierarchische Verwaltungsverfahren geschaffen bei dem die Grenzwerte in Hierarchieebenen eingeteilt werden. Jeder der Hierarchieebene kann eine logistische Ebene, wie z.B. eine Prozesseinheit, eine Produktgruppe, eine bestimmte Maschine, auf welcher das Produkt hergestellt wird, oder eine Operation, zugeordnet werden. Die hierarchische Einteilung kann beliebig anwendungsangepasst gewählt werden. Diese Wahl besteht aber vorzugsweise nur einmal beim Aufstellen der hierarchischen Verwaltung von Grenzwerten. Vorzugsweise werden die Grenzwerte in einer tabellenförmigen Übersicht hinterlegt. In den Spalten der Tabelle sind vorzugsweise die Hierarchieebenen angeordnet. In den Zeilen der tabellarischen Anordnung werden vorzugsweise für einen Prozessparameter für alle Objekt-Datensätze ein unterer und/oder oberer Grenzwert hinterlegt. D.h. innerhalb einer Zeile wird jedem Produkt entsprechend seiner Herstellungsgeschichte (Prozessschritte, welchen es unterzogen war, Rezepte, mit welchen es erstellt wurde, Maschinen, auf welchen es prozessiert wurde, usw.) ein Grenzwert für einen bestimmten Parameter zugewiesen.

Ein Vorteil des erfindungsgemäßen Verfahrens ist insbesondere, dass wegen des Verwendens von unspezifischen Objekt-Daten nicht für alle möglichen Kombinationen der verschiedenen Hierarchieebenen, d.h. Objekt-Datensätze ein Grenzwert hinterlegt werden muss. Hierdurch kann die Anzahl der benötigten Grenzwerte drastisch reduziert werden. Die Pflege der Grenzwerte wird somit vereinfacht. Weiterhin können erfindungsgemäß auch so genannte unspezifische Grenzwerte vergeben werden. Diese unspezifischen Grenzwerte sind Grenzwerte, welche für Objekt-Datensätze gültig sind, für welche keine spezifischen Grenzwerte hinterlegt wurden. D.h. für Objekt-Datensätze, bei denen in einer Hierarchieebene neue noch nicht verwendete Objekt-Daten auftreten. Insbesondere beziehen sich diese unspezifischen Grenzwerte auf neue Produkte, neue Prozessierungsschritte, neue Maschinen und/oder auf Produkte, für welche noch keine Grenzwerte hinterlegt wurden. D.h. Kombinationen von Hierarchieebenen, welche bisher noch nicht in eine Grenzwertüberwachung bzw. Grenzwertverwaltung aufgenommen wurden.

Es kann auch ein völlig unspezifischer Grenzwert hinterlegt werden, indem allen Hierarchieebenen unspezifische Objekt-Daten zugewiesen werden. Werden diese unspezifischen Grenzwerte klein gewählt, so erreicht man, dass diese unspezifischen Grenzwerte in einer erstmaligen Produktion, d.h. z.B. einer erstmaligen Produktion eines neuen Produktes, immer überschritten werden, so dass man zwangsläufig auf den zugehörigen Objekt-Datensatz aufmerksam wird und gegebenenfalls neue Grenzwerte für den entsprechenden Objekt-Datensatz hinterlegen kann.

Auch wenn die Erfindung im Weiteren an dem Beispiel eines Überwachungsverfahrens eines Wafer-Herstellungsverfahrens näher erläutert wird, ist darauf hinzuweisen, dass die Erfindung nicht darauf beschränkt ist, sondern in allen Überwachungsverfahren für Herstellungsverfahren, bei welchen im Herstellungsverfahren zum Herstellen eines physikalischen Objekts Prozessparameter aufgenommen werden, eingesetzt werden kann, beispielsweise auch in der Pharma-Industrie bei dem Herstellen von pharmazeutischen Produkten.

Ein Ausführungsbeispiel der Erfindung ist in den Figuren dargestellt und wird im Weiteren näher erläutert.

Es zeigen:
Figur 1 ein Blockdiagramm, in welchem die allgemeine Organisation einer Chip-Produktionsanlage dargestellt ist;
Figur 2 eine Skizze einer Chip-Produktionsanlage, wobei der komplexe Materialfluss, d.h. der Weg eines Wafers/Loses durch die Chip-Produktionsanlage und die damit vorhandenen komplexen Prozessschritte dargestellt ist;
Figur 3 ein Blockdiagramm, in dem der Prozessdatenfluss bei dem Herstellen eines Wafers/Loses dargestellt ist;
Figur 4 eine schematische Darstellung einer Hierarchie von Grenzwerten, welche in Form eines Baumes dargestellt ist, gemäß einem Ausführungsbeispiel der Erfindung;
Figur 5 eine schematische Darstellung einer Hierarchie von Grenzwerten, welche in Form einer Tabelle dargestellt ist, gemäß einem Ausführungsbeispiel der Erfindung, und
Figur 6 eine schematische Darstellung eines hierarchischen Aufbaus von Hierarchieebenen in der Form eines Baumes, gemäß einem Ausführungsbeispiel der Erfindung.

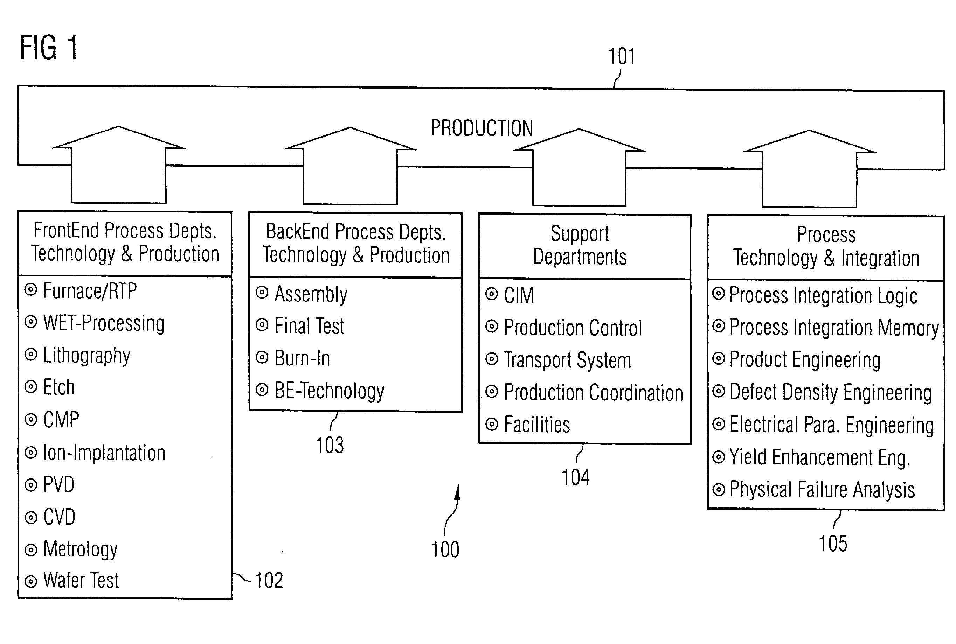

Einleitend wird in **Fig. 1** in einem Blockdiagramm 100 schematisch die Organisation und der Aufbau einer Halbleiterchip-Produktionsanlage, für welche ein erfindungsgemäßes Verfahren zum Überwachen eines Herstellungsprozesses einer Mehrzahl von Wafern verwendet werden kann, erläutert.

Der gesamte Herstellungsprozess, in Fig. 1 mit einem ersten Block 101 bezeichnet, wird beispielhaft in vier Produktionsbereiche 102, 103, 104, 105 gruppiert,
einen ersten Bereich, in den die Front-End-Prozesse der Chip-Fertigung gruppiert werden (Block 102),
einen zweiten Bereich des Herstellungsprozesses, in den die Back-End-Prozesse gruppiert werden (Block 103),
einen dritten Bereich des Herstellungsprozesses, der den Support betrifft, das heißt die Unterstützung der einzelnen Herstellungsprozesse (Block 104),
ein vierter Bereich der die Prozesstechnologie und die Prozessintegration betrifft (Block 105).

Bei den Front-End-Prozessen 102 sind insbesondere folgende Prozesstechnologien sowie die für die Durchführung der entsprechenden Prozesse eingerichteten Vorrichtungen vorgesehen:
Ein Ofen zum Erhitzen des jeweiligen zu prozessierenden Wafers, eine Vorrichtung zum Durchführen eines Kurzzeit-Temperverfahrens (Rapid Thermal Processing, RTP),
   eine Vorrichtung zum Ätzen des Wafers, beispielsweise zum Nassätzen oder zum Trockenätzen,
   eine Vorrichtung zum Reinigen, beispielsweise Waschen des Wafers,
   eine Vorrichtung zur Durchführung unterschiedlicher Lithographieschritte,
   eine Vorrichtung zum chemisch-mechanischen Polieren (Chemical Mechanical Polishing, CMP),
   eine Einrichtung zur Durchführung einer Ionen-Implantation in vorgegebenen Bereichen des Wafers bzw. des jeweils zu fertigenden Chips,
Vorrichtungen zum Aufbringen von Materialien auf dem Wafer, beispielsweise Vorrichtungen zum Abscheiden von Materialien aus der Gasphase, das heißt beispielsweise Vorrichtungen zum Durchführen von Physical Vapour Deposition (PVD) oder Chemical Vapour Deposition (CDV), oder eine Vorrichtung zum epitaktischen Aufwachsen von Material auf einem Substrat, Metrologie-Vorrichtungen, d.h. Messvorrichtungen, Vorrichtungen zum Durchführen von Tests auf den jeweiligen Wafern.

Die Back-End-Prozesse betreffen insbesondere folgende Bereiche:
Den Zusammenbau der Chips in Gehäuse,
den Endtest des gefertigten und gehäusten Chips,
das Einbringen von Informationen, beispielsweise Produktinformation, in oder an das Gehäuse des jeweiligen Chips, sowie
allgemein die im Bereich des Back-Ends für gehäuste und ungehäuste Chip eingesetzten Technologien.

Der Support, das heißt die Prozessunterstützung betrifft insbesondere folgende Bereiche:
CIM,
Prozessüberwachung,
ein Transportsystem zur Auslieferung der gefertigten Halbleiterchips,
eine Koordination der Produktion,
die Unterstützung der jeweiligen Fertigungsstandorte.

Die Prozesstechnologie und die Prozessintegration betrifft insbesondere
die Prozessintegration von Logikbausteinen,
die Prozessintegration von Speicherbausteinen,
das Produkt-Engineering,
das Überwachen und Verbessern von Fehlerdichten bei der Herstellung,
das Überwachen elektrischer Parameter bei den hergestellten Produkten,
die Verbesserung der Ausbeute der hergestellten Chips, eine physikalische Fehleranalyse.

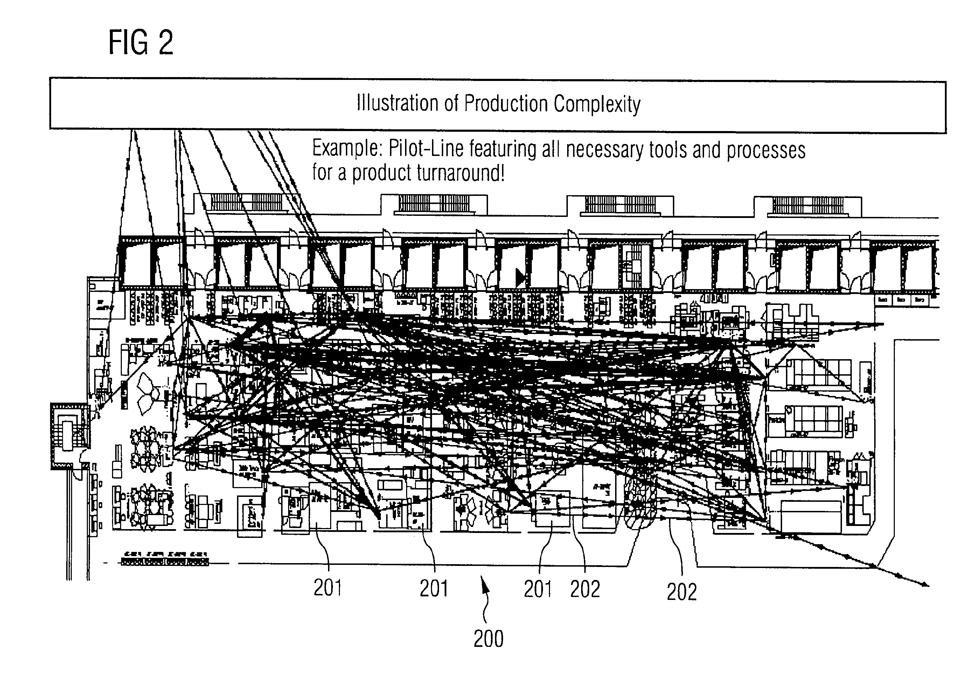

**Fig. 2** zeigt eine Halbleiterchip-Produktionsanlage, anders ausgedrückt eine Halbleiterchip-Fabrik 200 mit einer Vielzahl von Halbleiterchip-Teil-Produktionsanlagen 201, welche eingesetzt werden zur Bearbeitung von Rohmaterialien, beispielsweise eines.Siliziumwafers oder eines Wafers aus anderen Halbleiter-Materialien (Germanium, Gallium-Arsenid, Indium-Phosphid, etc.), um aus den Rohmaterialien Halbleiterchips zu fertigen.

Ein üblicher Herstellungsprozess zur Herstellung eines Halbleiterchips weist Hunderte von unterschiedlichen Prozessschritten auf, bei denen in unterschiedlicher Reihenfolge Lithographieschritte, Ätzschritte, CMP-Schritte, Schritte des Aufbringens von Materialien auf dem jeweiligen zu prozessierenden Wafer, oder auch Dotierungs- oder Implantationsschritte von Dotierungsatomen in den zu prozessierenden Wafer durchgeführt werden. Bei all diesem Prozessschritten werden Werte von Prozessparametern aufgenommen, welche einer späteren statistischen Analyse unterworfen werden können.

Somit ergeben sich die in Fig. 2 durch Linien 202 dargestellten Wege, welche den Weg eines Wafers,oder eines Loses durch die Halbleiterchip-Produktionsanlage 200 darstellen. In der Halbleiterchip-Produktionsanlage 200 ist eine Vielzahl von Sensoren, welche den jeweiligen Teil-Produktionsanlagen 201 zugeordnet sind und eine noch größere Menge von Prozessdaten (Rohdaten) werden aufgenommen, welche jeweils von den Sensoren erfasst werden und, wie im Weiteren näher erläutert wird, verarbeitet werden. Ein jeweiliger Sensor kann in eine jeweilige Maschine integriert sein (integrierter Sensor) oder separat an eine jeweilige Maschine angebaut sein (externer Sensor).

Im Weiteren werden die Teil-Produktionsanlagen 201 auch als Maschinen 201 bezeichnet.

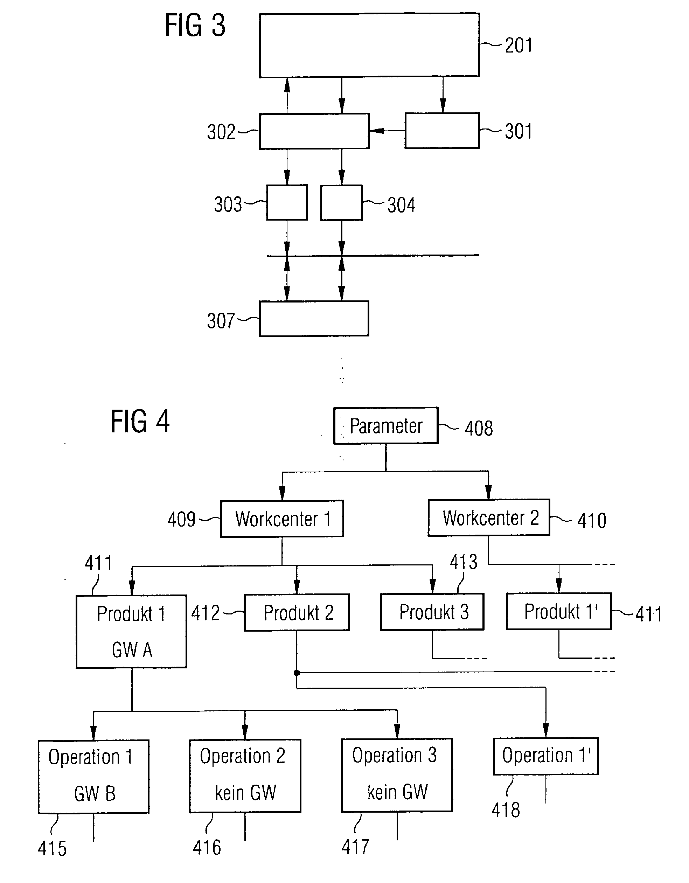

**Fig.3** zeigt beispielhaft den Datenfluss für Prozessdaten, welche an einer Maschine 201 mittels eines integrierten oder mittels eines externen Sensors 301. Jeder Sensor 301, wobei eine beliebige Anzahl integrierter und/oder externer Sensoren vorgesehen sein können, erfasst die jeweils für ihn vorgegebenen Parameter der Maschine 201, beispielsweise physikalische oder chemische Zustände in einer Prozesskammer, die Position eines Roboterarms, etc. Beispiele für Prozessparameter bei der Herstellung eines Wafers sind zum Beispiel die Dejustierung, d.h. die PositionierungsUngenauigkeit, innerhalb eines Positionierungsschrittes, Temperatur während eines Prozessschrittes, Gasfluss während eines Prozessschrittes, Zeitdauer eines Prozessschrittes oder der Druck während eines Prozessschrittes.

Der Sensor 301 ist über eine SECS-Schnittstelle 302, die eingerichtet ist zur Datenkommunikation gemäß den SECS-Standards mit einem lokalen Kommunikationsnetz (Local Area Network, LAN) 306 gekoppelt.

Gemäß den SECS-Standards werden von dem Sensor 301 und der SECS-Schnittstelle 302 Dateien gemäß dem PDSF-Format (Process Data Standard Format) erzeugt, im Weiteren auch bezeichnet als PDSF-Dateien 303 sowie Protokolldateien 304, wobei die PDSF-Dateien 303 und die Protokolldateien 304 als Daten in einem Speicher 307 gespeichert werden.

Die PDSF-Dateien 303 enthalten z.B. analoge Daten von unterschiedlichen Kanälen, das heißt von unterschiedlichen internen (d.h. integrierten) und/oder externen Sensoren 301, welche an einer Maschine 201 angebracht sein können. Die erzeugten Prozessdaten werden in dem Speicher 307 gespeichert und stehen nachfolgend für die Überwachung des Herstellungsprozesses und der Grenzwertüberwachung zur Verfügung.

Zum Überwachen des Herstellungsprozesses und der Grenzwertüberwachung wird eine Auswertung der in Speicher 307 gespeicherten Prozessdaten mittels eines Rechners durchgeführt. Ein erfindungsgemäßes Verfahren zum Auswerten wird in den nachfolgenden Figuren erläutert.

In **Fig. 4** ist schematisch ein hierarchischer Baum dargestellt. Der hierarchische Baum verdeutlicht die Struktur, in der die aufgenommenen und in Speicher 307 gespeicherten Prozessdaten für eine Auswertung mittels des Rechners hinterlegt werden können, und für einen rechnergestützten Vergleich mit hinterlegten Grenzwerten für die Prozessdaten zur Verfügung stehen. Als höchste Hierarchieebene des hierarchischen Baumes ist der Parameter 408, d.h. der Prozessparameter, für welchen ein Grenzwert hinterlegt werden soll, aufgeführt. Dieser Parameter 408 kann zum Beispiel die Dejustage, d.h. die Abweichung in X- und/oder Y-Richtung von einer Sollposition des Wafers, welche Sollposition er bei der Prozessierung einnehmen soll, sein. Die hierarchische Reihenfolge der Hierarchieebenen kann beliebig jedoch nur einmal zu Beginn des Aufbaus der Grenzwertverwaltung vorgegeben werden.

Als zweite Hierarchieebene kommt gemäß dem Ausführungsbeispiel die Ebene der Workcenter. In Fig. 4 sind Workcenter I 409 und Workcenter II 410 dargestellt. Diese Workcenter kennzeichnen den Teil der Produktionsanlage auf welchem ein betreffender Wafer hergestellt wird. Der Grenzwert für den Parameter 408 der Dejustage kann im Ausführungsbeispiel für Produkte aus zwei Workcentern hinterlegt werden.

Eine dritte Hierarchieebene bezieht sich auf verschiedene Produkte, welche in den verschiedenen Workcenter hergestellt werden können. Im Ausführungsbeispiel sind dies Produkte I 411, Produkt II 412 und Produkt III 413, welche im Workcenter I 409 und im Workcenter II 410 hergestellt werden. Der Übersichtlichkeit wegen ist für das Workcenter II 410 nur das Produkt I' 414 dargestellt. Im Ausführungsbeispiel ist für das Produkt I 411 ein Grenzwert A hinterlegt. Dieser Grenzwert A gilt im Ausführungsbeispiel somit für den Parameter Dejustage an Wafern des Produktes I, welche im Workcenter I 409 hergestellt wurden.

Als vierte Hierarchieebene sind schematisch verschiedene Operationen dargestellt, welche zum Herstellen des Produktes I 411 verwendet werden. Dies sind Operation I 415, Operation II 416 und Operation III 417. Die vierte Hierarchieebene ist für die weiteren Produkte 412, 413 und 414 der Übersichtlichkeit wegen nur angedeutet. Diese vierte Hierarchieebene kennzeichnet mittels welcher Operationen ein bestimmtes Produkt hergestellt werden kann. Im Ausführungsbeispiel ist für die Operation I 415 ein Grenzwert B hinterlegt, während für die Operation II 416 und Operation III 417 kein Grenzwert hinterlegt ist. Als Grenzwerte, welche für das Produkt I 411 für den Parameter Dejustage eingehalten werden müssen ergeben sich gemäß einer hierarchischen Abarbeitung des Vergleiches von hinterlegten Grenzwerten und damit verknüpften Prozessparametern nun folgende Werte. Für ein Produkt I 410, welches gemäß der Operation I 415 im Workcenter I 409 hergestellt wurde, ist ein spezieller Grenzwert B für die Dejustage hinterlegt. Für ein Produkt I 410, welches gemäß der Operation II 416 oder Operation III 417 im Workcenter I hergestellt wurde, ist kein spezieller Grenzwert für die Dejustage hinterlegt. Durch dem hierarchischen Aufbau ergibt sich jedoch ein Grenzwert, welcher eingehalten werden muss. Als Grenzwert ergibt sich der Grenzwert, welcher für die vorhergehende Hierarchieebene hinterlegt wird. Im Ausführungsbeispiel ist dies der Grenzwert A, welcher für das Produkt I 411 hinterlegt wird.

Für das Produkt II 412 ist schematisch nur eine Operation I' 418 dargestellt. Zusätzliche Operationen sind der Übersichtlichkeit wegen nur angedeutet.

Anhand des hierarchischen Baumes wird ein Vorteil der erfindungsgemäßen Verfahrens des Hinterlegens von Grenzwerten verdeutlicht. Es muss nicht für alle Kombinationen von Hierarchieebenen ein spezieller Grenzwert hinterlegt werden, um für jede Kombination von Hierarchieebenen (Objekt-Datensatz) einen Grenzwert bereitzustellen. Durch den hierarchischen Aufbau ist es möglich die Anzahl der Grenzwerte zu verringern. Ein nicht vorhandener spezifischer Grenzwert für einen Objekt-Datensatz wird erfindungsgemäß durch einen Grenzwert ersetzt, welcher als unspezifischer Grenzwert hinterlegt wird.

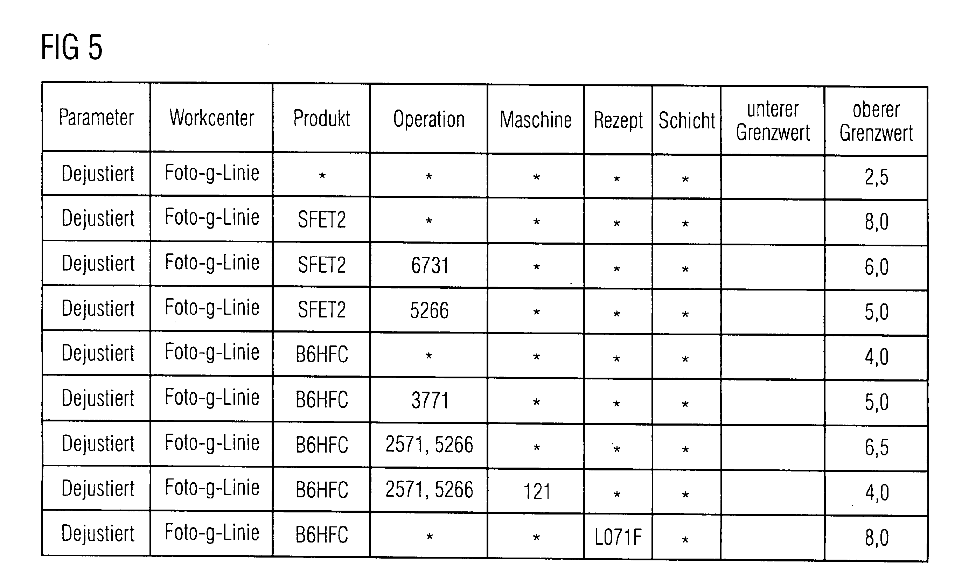

In **Fig. 5** ist schematisch eine Hierarchie von Grenzwerten in Form einer Tabelle gemäß dem Ausführungsbeispiel der Erfindung dargestellt. Die Tabelle verdeutlicht eine alternative Struktur, in der die aufgenommenen und in Speicher 307 gespeicherten Prozessdaten für eine Auswertung mittels des Rechners hinterlegt werden können, und für einen rechnergestützten Vergleich mit hinterlegten Grenzwerten für die Prozessdaten zur Verfügung stehen. Die dargestellte Tabelle ist entsprechend des erfindungsgemäßen Verfahrens einer Lithographie einer Wafer-Produktionsanlage dargestellt. Die Produktion von Halbleiterbausteinen wird durch eine Reihe von Hierarchieebenen gekennzeichnet. Ein spezielles Produkt aus einer Gesamtheit aller zu einer Zeit in Produktion stehender Produkte ist z.B. mittels seines Losnamens, einer Technologie, einer Operation und eines Rezeptes charakterisiert. Mit dieser Charakterisierung ist gekoppelt mittels welcher Maschinen, mit welchen vorgegebenen Prozessparametern das spezielle Produkt hergestellt werden muss und wie die Grenzwerte für die vorgegebenen Prozessparameter sind.

In der Tabelle sind die einzelnen Hierarchieebenen in den Spalten aufgeführt. Als erste Hierarchieebene, d.h. die erste Spalte in der Tabelle, wird wie in Figur 4 der Prozessparameter verwendet. Auch hier wird beispielhaft wiederum der Parameter Dejustage dargestellt, d.h. es wird im Ausführungsbeispiel der Parameter "Dejustiert" überwacht.

Als zweite Hierarchieebene, d.h. zweite Spalte der Tabelle, wird die Hierarchieebene "Workcenter" verwendet. In Figur 5 ist dies nur das Workcenter I oder anders ausgedrückt eine Gruppe von Produktionsmaschinen.

Die dritte Hierarchieebene, d.h. die dritte Spalte der Tabelle, ist das "Produkt", welches überwacht werden soll. In der Tabelle sind hierzu zwei verschiedene Produkte eingetragen. Die erste Zeile der dritten Spalte ist mit einen "*" markiert. Dieser Stern bedeutet die Eintragung für einen unspezifischen Wert einer Hierarchieebene, d.h. ein unspezifisches Objekt-Datum. In der zweiten bis vierten Zeile ist ein ersten spezifisches Produkt SFET2 eingetragen, während in der fünften bis neunten Zeile ein zweites spezielles Produkt B6HFC eingetragen ist. Dieses unspezifisches Objekt-Datum einer Hierarchieebene bedeutet, dass es für alle möglichen Objekt-Daten steht, welche möglich sind, außer für in der gleichen Hierarchieebene genauer spezifizierten Objekt-Daten.

Als vierte Hierarchieebene, d.h. vierte Spalte der Tabelle, wird die Hierarchieebene "Operation" verwendet. Unter Operation wird hier ein Verfahrenschritt des Herstellungsverfahrens verstanden. In der Tabelle sind hier in der ersten, zweiten, fünften und neunten Zeile wiederum unspezifische Objekt-Daten ("*") eingetragen. In der dritten Zeile ist die Operation 6731, in der vierten Zeile die Operation 5266, in der sechsten Zeile die Operation 3771 und in der siebten und achten Zeile sind die Operationen 2571 und 5266 eingetragen.

Als fünfte Hierarchieebene, d.h. fünften Spalte der Tabelle, wird die Hierarchieebene "Maschine" verwendet. In der fünften Spalte ist nur in der achten Zeile ein speziellen Wert von 121 eingetragen. In der ersten bis siebten Zeile und in der neunten Zeile sind wiederum unspezifische Objekt-Daten "*" eingetragen.

Als sechste Hierarchieebene, d.h. sechste Spalte der Tabelle, wird die Hierarchieebene "Rezept" verwendet. Unter Rezept ist hier das Rezept zu verstehen, mittels welchem das einzelne Produkt hergestellt wird. In der sechsten Hierarchieebene ist nur in der neunten Zeile ein Objekt-Datum von L071F eingetragen. In der ersten bis achten Zeile ist ein unspezifischer Wert "*" eingetragen.

Als siebte Hierarchieebene, d.h. siebte Spalte der Tabelle, würde die Hierarchieebene "Schicht" zur Verfügung stehen. Diese siebte Hierarchieebene wird im Ausführungsbeispiel nicht verwendet und somit wird in allen Zeilen der unspezifische Wert "*" eingetragen.

Die achte Spalte der Tabelle steht für einen unteren Grenzwert zur Verfügung. Ein unterer Grenzwert hat für den Prozessparameter "Dejustage" jedoch keinen Sinn, da er eine Mindestdejustage bedeuten würde, und wird somit in der Tabelle mit keinem Wert belegt.

Die neunte Spalte der Tabelle steht schließlich für den oberen Grenzwert des Prozessparameters "Dejustage" zur Verfügung. In der ersten Zeile steht hier ein Wert von 2,5, in der zweiten Zeile ein Wert von 8, in der dritten Zeile ein Wert von 6, in der vierten Zeile ein Wert von 5, in der fünften Wert ein Wert von 4, in der sechsten Zeile ein Wert von 5, in der siebten Zeile ein Wert von 6,5, in der achten Zeile ein Wert von 4 und in der neunten Zeile ein Wert von 8. Diese Werte stellen die oberen Grenzwerte dar, welche für ein Produkt, welches die entsprechende Herstellungshistorie hatte, gelten und somit nicht überschritten werden dürfen. Vorzugsweise werden die oberen Grenzwerte der Dejustage in relativen Einheiten, z.B. in ppm (parts per million), angegeben. Sie können auch in absoluten Einheiten wie zum Beispiel µm angegeben werden.

Anhand dieser Tabelle soll nun noch für einige Beispiele Beispielhaft das hierarchische Verwalten und die hierarchische Abarbeitung beim Vergleich der Grenzwerte mit gemessenen Prozessparametern für einen Objekt-Datensatz erläutert werden.

Der hinterlegte obere Grenzwert in der ersten Zeile von 2,5 ist der minimale obere Grenzwert. Dieser gilt für alle später in der Tabelle nicht genauer spezifizierten Kombinationen und somit auch für neue oder noch nicht überwachte Kombinationen. Aus diesem Grund ist der Grenzwert auch minimal gewählt, so dass er bei einem entsprechenden neuen oder noch nicht überwachten Produkt auf alle Fälle überschritten wird. Somit ist sichergestellt, dass sofort bei eventuell fehlenden Grenzwerte alarmiert wird.

Der in Zeile zwei angegebene obere Grenzwert von 8 gilt für alle Objekt-Datensätze, welche für ein Produkt SFET2 möglich sind, wobei das Produkt SFET2 im "Foto g-line" hergestellt wurde, sofern für dieses Produkt SFET2 nicht in einer späteren Zeile ein spezifischerer oberer Grenzwert hinterlegt ist. Ein spezifischerer oberer Grenzwert ist zum Beispiel in Zeile drei für ein Produkt SFET2 angegeben, welches mittels der Operation 6731 hergestellt wird. Für ein Produkt SFET2, welches mittels Operation 6731 hergestellt wird, beträgt der obere Grenzwert der Dejustage 6. Ein weiterer spezifischerer oberer Grenzwert ist in Zeile vier für ein Produkt SFET2 angegeben, welches mittels der Operation 5266 hergestellt wird. Für ein Produkt SFET2, welches mittels Operation 5266 hergestellt wird, beträgt der obere Grenzwert der Dejustage 5.

Der in Zeile fünf angegebene obere Grenzwert von 4 gilt wiederum für alle Objekt-Datensätze, welche für ein Produkt B6HFC möglich sind, wobei das Produkt B6HFC im "Foto g-line" hergestellt wurde, sofern für dieses Produkt B6HFC nicht in einer späteren Zeile ein spezifischerer oberer Grenzwert hinterlegt ist. Dies ist daran ersichtlich, da in der vierten bis siebten Spalte der fünften Zeile nur "*" als Wert eingetragen ist. Der Grenzwert von 4 ist somit ein unspezifischer oberer Grenzwert für alle Produkte B6HFC, welche im Workcenter "Foto g-line" hergestellt wurden.

Ein spezifischerer oberer Grenzwert ist zum Beispiel in Zeile sechs für ein Produkt B6HFC angegeben, welches mittels der Operation 3771 hergestellt wird. Für ein Produkt B6HFC, welches mittels Operation 3771 hergestellt wird, beträgt der obere Grenzwert der Dejustage 5.

Ein weiterer spezifischerer oberer Grenzwert ist in Zeile sieben für ein Produkt B6HFC angegeben, welches mittels der Operation 2571, oder 5266 hergestellt wird. Für ein Produkt B6HFC, welches mittels Operation 2571 oder 5266 hergestellt wird, beträgt der obere Grenzwert der Dejustage 6,5, solange nicht ein noch spezifischerer oberer Grenzwert angegeben ist.

In Zeile acht erkennt man, dass für ein Produkt B6HFC, welches mittels der Operation 2571 oder 5266 hergestellt wird, für den Fall das es mittel der Maschine 121 hergestellt wird ein spezifischerer oberer Grenzwert von 4 hinterlegt ist.

In der neunten Zeile schließlich ist für die Dejustage ein spezifischer oberer Grenzwert von 8 für ein Produkt B6HFC angegeben. Der Grenzwert von 8 gilt für das Produkt B6HFC, welches mit dem Rezept L071F hergestellt wurde, solange es nicht mittels der Operation 3771, 2571 oder 5266 hergestellt wird.

Anhand der Tabelle kann man erkennen, dass erfindungsgemäß jedem Produkt je nach Herstellungshistorie ein unterschiedlicher Grenzwert für einen Prozessparameter zugewiesen werden kann. Hierbei werden alle möglichen Objekt-Datensätze abgedeckt, ohne dass allen möglichen Objekt-Datensätzen ein spezifischer Grenzwert zugeordnet ist. Dies wird erreicht in dem die unspezifischen Objekt-Daten "*" verwendet werden. Mittels des hierarchischen Aufbaus der Grenzwertverwaltung kann die Anzahl der zu hinterlegenden Grenzwerte und damit der Aufwand bei der Überwachung von Prozessparametern drastisch reduziert werden. So reichen in einer beispielhaften Lithographieanlage die Anzahl von 700 hinterlegten Grenzwerte aus, um eine Kombinationsanzahl von Hierarchieebenen von rund 340.000 abzudecken. Diese starke Reduktion der benötigten Grenzwerte erhöht die Übersichtlichkeit und Pflegbarkeit der Grenzwertverwaltung.

Beispielhaft wird nun anhand eines Beispiels eine Abarbeitung beim Vergleich gemessener Prozessdaten mit hinterlegten Grenzwerten für diese Prozessdaten durchgeführt. Beispielsweise ist ein Objekt-Datensatz eines Wafers durch den Prozessparameter "Dejustiert", das Workcenter "Foto-g-line", das Produkt "B6HFC", die Operation "8641", die Maschine "121" und durch das Rezept "L071F" gegeben. Zum Durchführen des rechnergestützten Vergleichs wird nun ein hierarchisches Abarbeiten der einzelnen Objekt-Daten mittels eines Rechners durchgeführt. Als erstes wird der Prozessparameter und das Workcenter abgearbeitet. In der Tabelle der Figur 5 sind nur die entsprechenden Objekt-Daten "Dejustiert" und "Foto-g-line" berücksichtigt. Beim Abarbeiten der nächsten Hierarchieebene "Produkt" sind in der Tabelle zwei Produkte mit speziellen Objekt-Daten berücksichtigt. Für Produkt "B6HFC" sind die Zeilen 5 bis 9 der Tabelle abzuarbeiten. Im beispielhaften Objekt-Datensatz des Wafers ist für die nächste Hierarchieebene "Operation" für zwei Objekt-Daten ein spezifischer Wert hinterlegt. Wenn dieser beispielhafte Objekt-Datensatz abgearbeitet wird, so ergibt sich, dass die Operation 8641 nicht in der Tabelle spezifiziert ist. Bei der Abarbeitung des beispielhaften Objekt-Datensatzes bleiben beim Vergleich also noch die Zeilen fünf und neun zum Bestimmen des hinterlegten Grenzwertes übrig. Auch nach Abarbeitung der nächsten Hierarchieebene "Maschine" bleiben diese beiden Zeilen fünf und neun der Tabelle übrig. Beim Abarbeitungsschritt der Hierarchieebene "Rezept" ergibt sich, dass das Objekt-Datum "L071F" in der neunten Zeile spezifiziert ist. Somit ergibt sich beim hierarchischen Abarbeiten des Vergleichs, dass der Grenzwert für den entsprechenden Prozessparameter für den beispielhaften Objekt-Datensatz "8" beträgt. D.h., das Produkt, welches den entsprechenden Objekt-Datensatz aufweist, erfüllt den hinterlegten Grenzwert, wenn die Dejustage nicht mehr als "8" beträgt.

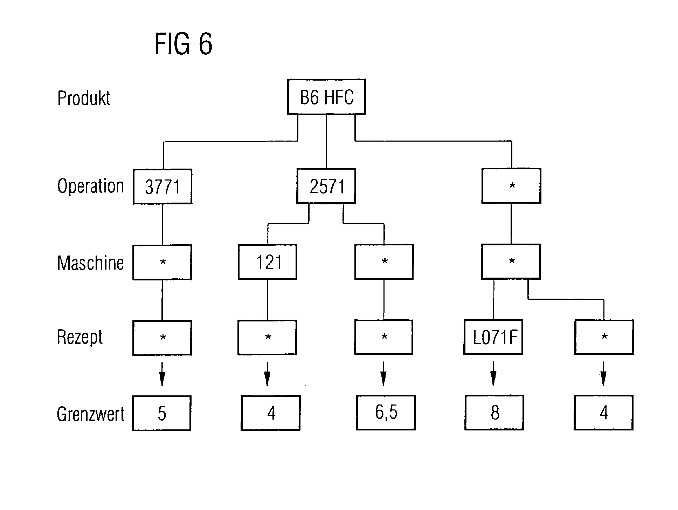

In **Fig. 6** ist schematisch der hierarchische Aufbau für das Produkt B6HFC aus der Tabelle der Fig. 5 in Baumform dargestellt. Anhand dieses Aufbaus erkennt man die hierarchische Abarbeitung beim Vergleich des gemessenen Prozessparameters "Dejustage" mit dem für die entsprechenden Datensätze hinterlegten Grenzwerte.

Ausgehend vom Produkt wird zunächst die nächste Hierarchieebene, d.h. alle spezifizierten Operationen, für dieses Produkt abgearbeitet. Dies sind in Fig. 6 die Operation 3771, die Operation 2571 und die unspezifische Operation "*". Die in der Tabelle der Fig. 5 noch spezifizierte Operation 5266 wurde der Übersichtlichkeit halber weggelassen.

Als nächstes wird die nächste Hierarchieebene, d.h. die spezifizierten Maschinen, für dieses Produkt abgearbeitet. Hier wird ausgehend von der Operation 3771 nur das unspezifische Objekt-Datum "*" hinterlegt. Ausgehend von der Operation 2571 wird die Maschine 121 und das unspezifische Objekt-Datum "*" hinterlegt und ausgehend von der unspezifischen Operation "*" wird nur das unspezifische Objekt-Datum "*" hinterlegt.

Als nächstes wird die nächste Hierarchieebene, d.h. die spezifizierten Rezepte, für dieses Produkt abgearbeitet. Hier wird ausgehend vom unspezifischen Datum im Zweig der Operation 3771 nur das unspezifische Objekt-Datum "*" hinterlegt.

Ausgehend von der Maschine 121 wird nur das unspezifische Objekt-Datum "*" hinterlegt. Ausgehend vom unspezifischen Datum im Zweig der Operation 2571 wird nur das unspezifische Objekt-Datum "*" hinterlegt und ausgehend von der unspezifischen Maschine "*" im Zweig der unspezifischen Operation "*" wird das spezifische Rezept L071F und das unspezifische Objekt-Datum "*" hinterlegt.

Somit erhält man den in Fig. 6 dargestellten hierarchischen Baum. Den einzelnen Zweigen des hierarchischen Baumes werden nun die einzelnen hinterlegten Grenzwerte zugeordnet. Die einzelnen Zweige stellen gleichzeitig die einzelnen Objekt-Datensätze dar. Dem ersten dargestellten Objekt-Datensatz (Produkt B6HFC, Operation 3771, Maschine "*", Rezept "*") wird der Grenzwert 5 für den Prozessparameter Dejustage zugeordnet. Dem zweiten dargestellten Objekt-Datensatz (Produkt B6HFC, Operation 2571, Maschine 121, Rezept "*") wird der Grenzwert 4 für den Prozessparameter Dejustage zugeordnet. Dem dritten dargestellten Objekt-Datensatz (Produkt B6HFC, Operation 2571, Maschine "*", Rezept "*") wird der Grenzwert 6,5 für den Prozessparameter Dejustage zugeordnet. Dem vierten dargestellten Objekt-Datensatz (Produkt B6HFC, Operation "*", Maschine "*", Rezept L071F) wird der Grenzwert 8 für den Prozessparameter Dejustage zugeordnet und dem fünften dargestellten Objekt-Datensatz (Produkt B6HFC, Operation "*", Maschine "*", Rezept "*") wird der Grenzwert 4 für den Prozessparameter Dejustage zugeordnet. Dieser fünfte Objekt-Datensatz stellt gleichzeitig einen völlig unspezifischen Objekt-Datensatz dar, welcher für alle nicht näher spezifizierte Objekt-Datensätze für das Produkt B6HFC gültig ist. Der dem fünften Objekt-Datensatz zugeordnete Grenzwert von 4 gilt somit auch für die Grenzwertüberwachung aller neuen Produkte oder noch nicht überwachten Produkte.

Auch anhand der Darstellung in Figur 6 wird kurz die hierarchische Abarbeitung beim rechnergestützten Vergleich von gemessenen Werten für Prozessparameter und gespeicherten Grenzwerten für diese Prozessparameter beispielhaft anhand des gleichen Objekt-Datensatzes eines Wafers wie oben (B6HFC, 8641, 121, L071F) erläutert. Das Objekt-Datum der höchsten in Figur 6 berücksichtigten Hierarchieebene (Produkt) und das Objekt-Datum im beispielhaften Objekt-Datensatz stimmt überein. Bei der hierarchischen Abarbeitung mittels eines Rechners kommt nun als nächste Hierarchieebene die "Operation" und es wird bei der Auswertung entschieden, in welchen in der Figur 6 dargestellten Zweig der gesuchte Grenzwert zu finden ist. Spezifiziert sind in Figur 6 nur Operation 3771 und 2571. Daher ergibt sich für ein Produkt B6HFC, welches mittels der Operation 8641 hergestellt wurde, dass sich der hinterlegte Grenzwert des Prozessparameters in dem Zweig befindet, welcher mittels des unspezifischen Objekt-Datums "*" gekennzeichnet ist. Dies ist in Figur 6 der Zweig ganz rechts. Zur weiteren hierarchischen Abarbeitung betrachtet der Rechner als nächstes die Hierarchieebene "Maschine. Im rechten Zweig des in Figur 6 dargestellten hierarchischen Baumes ist keine Maschine spezifiziert, d.h. dass diese Hierarchieebene, in welcher im beispielhaften Objekt-Datensatz des Wafers "121" hinterlegt ist, für einen Vergleich keine weitere Verzweigung des Baumes ergibt. Zum Abschluss der rechnergestützten hierarchischen Abarbeitung wird noch die Hierarchieebene "Rezept" berücksichtigt. Hier ist im rechten Zweig des in Figur 6 dargestellten Baumes ein Rezept "L071F" spezifiziert. Das spezifizierte Objekt-Datum für das Rezept stimmt mit dem Objekt-Datum "L071F" des beispielhaften Objekt-Datensatz überein. Somit ergibt sich bei der hierarchischen Abarbeitung für den Prozessparameter des beispielhaften Objekt-Datensatz ein Grenzwert von "8".

Zusammenfassend schafft die Erfindung ein Verfahren zum Überwachen von Prozessparametern eines Herstellungsprozesses eines physikalischen Objektes, bei welchen die Anzahl der zu hinterlegenden Grenzwerte drastisch reduziert werden kann, indem die Grenzwertverwaltung hierarchisch strukturiert wird. Durch diese hierarchische Strukturierung muss nicht mehr für jede Kombination von Hierarchieebenen ein spezifischer Grenzwert hinterlegt werden. Das Erfindungsgemäße Verfahren erhöht die Pflegbarkeit der Grenzwertverwaltung und bietet zusätzlich die Möglichkeit auch neue Produkte oder noch nicht gepflegte Produkte einer Überwachung zuzuführen.

In diesem Dokument sind folgende Dokumente zitiert:
[1] US 2002/0055194
[2] US 5 726 920
[3] C. Schneider et al., IEEE/SEMI Advanced Semiconductor Manufacturing Conference, April 2001, S. 33-40

### Bezugszeichenliste

- 100: schematisches Blockdiagramm eines Aufbaus einer Halbleiter-Produktionsanlage
- 101: Block eines gesamten Herstellungsprozesses
- 102: Block eines ersten Produktionsbereiches
- 103: Block eines zweiten Produktionsbereiches
- 104: Block eines dritten Produktionsbereiches
- 105: Block eines vierten Produktionsbereiches
- 200: Halbleiterchip-Produktionsanlage
- 201: Vielzahl von Halbleiterchip-Teil-Produktionsanlagen
- 202: Weg eines Wafers oder Loses durch die Halbleiterchip-Produktionsanlage
- 201: Maschine
- 301: Sensor
- 302: SECS-Schnittstelle
- 303: PDSF-Datei
- 304: Protokolldatei
- 306: lokales Kommunikationsnetz (LAN)
- 307: Speicher
- 408: Prozessparameter
- 409: Workcenter I
- 410: Workcenter II
- 411: Produkt I
- 412: Produkt II
- 413: Produkt III
- 414: Produkt IV
- 415: Operation I
- 416: Operation II
- 417: Operation III
- 418: Operation I'

## Patentansprüche

1. Verfahren zur rechnergestützten Überwachung von Prozessparametern eines Herstellungsprozesses eines physikalischen Objektes, wobei Objekt-Daten, welche das physikalische Objekt kennzeichnen, verschiedenen Hierarchieebenen zugeordnet sind, wobei Objekt-Daten verschiedener Hierarchieebenen zu hierarchischen Objekt-Datensätzen gruppiert sind, wobei Grenzwerte für mindestens einen Prozessparameter gespeichert und jeweils einem hierarchischen Objekt-Datensatz zugeordnet sind, wobei bei der Herstellung physikalischer Objekte gemessene Prozessdaten des mindestens einen Prozessparameters gespeichert sind und wobei für hergestellte physikalische Objekte die den Objekt-Daten entsprechenden hierarchischen Objekt-Datensätze ermittelt sind;
bei dem, wenn für eine Hierarchieebene kein spezifischer Wert im Objekt-Datensatz hinterlegt wird, ein unspezifischer Wert für die Hierarchieebene hinterlegt wird;
bei dem die für die entsprechenden Objekt-Datensätze gespeicherten Prozessdaten mit den gespeicherten Grenzwerten für die entsprechenden Objekt-Datensätze verglichen werden;
wobei bei dem Vergleich die Hierarchieebenen des Objekt-Datensatzes der gespeicherten Prozessdaten derart gemäß einer vorgebbaren Hierarchie iterativ abgearbeitet werden, dass ausgehend von einer höchsten Hierarchieebene solange die nächstniedrigere Hierarchieebene abgearbeitet wird, bis die Abarbeitung die niedrigste Hierarchieebene erreicht hat; und
wobei bei dem Abarbeiten, der unspezifische Wert einer Hierarchieebene des Objekt-Datensatzes verwendet wird, wenn der Wert der Hierarchieebene nicht als spezifischer Wert hinterlegt ist.

2. Verfahren gemäß Anspruch 1, bei dem das physikalische Objekt ein Wafer ist.

3. Verfahren gemäß Anspruch 1 oder 2, bei dem die Hierarchieebenen logistischen Ebenen des Herstellungsprozesses entsprechen.

4. Verfahren gemäß einem der Ansprüche 1 bis 3, bei dem unspezifische Grenzwerte für Prozessparameter hinterlegt werden, indem unspezifische Objekt-Daten verwendet werden.

5. Verfahren gemäß einem der Ansprüche 1 bis 4, bei dem die Werte des mindestens einen Prozessparameters gemessen werden.

6. Verfahren gemäß einem der Ansprüche 1 bis 5, bei dem die Hierarchieebenen gemäß einem vorgebbaren Sortierungskriterium sortiert werden.

7. Vorrichtung rechnergestützten Überwachen von Prozessparametern eines Herstellungsprozesses eines physikalischen Objekts, wobei Objekt-Daten, welche das physikalische Objekt kennzeichnen, verschiedenen Hierarchieebenen zugeordnet sind, wobei Objekt-Daten verschiedener Hierarchieebenen zu hierarchischen Objekt-Datensätzen gruppiert sind, wobei Grenzwerte für mindestens einen Prozessparameter gespeichert und jeweils einem hierarchischen Objekt-Datensatz zugeordnet sind, wobei bei der Herstellung physikalischer Objekte gemessene Prozessdaten des mindestens einen Prozessparameters gespeichert sind und wobei für hergestellte physikalische Objekte die den Objekt-Daten entsprechenden hierarchischen Objekt-Datensätze ermittelt sind, mit einem Prozessor, der derart eingerichtet ist, dass folgende Verfahrensschritte durchführbar sind:
Hinterlegen eines unspezifischen Wertes für die Hierarchieebene, wenn für eine Hierarchieebene kein spezifischer Wert im Objekt-Datensatz hinterlegt wird Vergleichen von für die entsprechenden Objekt-Datensätze gespeicherten Prozessdaten mit den gespeicherten Grenzwerten für die entsprechenden Objekt-Datensätze;
iteratives Abarbeiten der Hierarchieebenen des Objekt-Datensatzes der gespeicherten Prozessdaten gemäß einer vorgebbaren Hierarchie beim Vergleich, wobei ausgehend von einer höchsten Hierarchieebene solange die nächstniedrigere Hierarchieebene abgearbeitet wird, bis die Abarbeitung die niedrigste Hierarchieebene erreicht hat und wobei bei dem Abarbeiten, der unspezifische Wert einer Hierarchieebene des Objekt-Datensatzes verwendet wird, wenn der Wert der Hierarchieebene nicht als spezifischer Wert hinterlegt ist.

8. Computerlesbares Speichermedium, in dem ein Programm zum Überwachen eines Herstellungsprozesses eines physikalischen Objektes gespeichert ist, wobei Objekt-Daten, welche das physikalische Objekt kennzeichnen, verschiedenen Hierarchieebenen zugeordnet sind, wobei Objekt-Daten verschiedener Hierarchieebenen zu hierarchischen Objekt-Datensätzen gruppiert sind, wobei Grenzwerte für mindestens einen Prozessparameter gespeichert und jeweils einem hierarchischen Objekt-Datensatz zugeordnet sind, wobei bei der Herstellung physikalischer Objekte gemessene Prozessdaten des mindestens einen Prozessparameters gespeichert sind und wobei für hergestellte physikalische Objekte die den Objekt-Daten entsprechenden hierarchischen Objekt-Datensätze ermittelt sind, das, wenn es von einem Prozessor ausgeführt wird, folgende Verfahrensschritte aufweist:
Hinterlegen eines unspezifischen Wertes für die Hierarchieebene, wenn für eine Hierarchieebene kein spezifischer Wert im Objekt-Datensatz hinterlegt wird;
Vergleichen von für die entsprechenden Objekt-Datensätze gespeicherten Prozessdaten mit den gespeicherten Grenzwerten für die entsprechenden Objekt-Datensätze;
iteratives Abarbeiten der Hierarchieebenen des Objekt-Datensatzes der gespeicherten Prozessdaten gemäß einer vorgebbaren Hierarchie beim Vergleich, wobei ausgehend von einer höchsten Hierarchieebene solange die nächstniedrigere Hierarchieebene abgearbeitet wird, bis die Abarbeitung die niedrigste Hierarchieebene erreicht hat, und wobei bei dem Abarbeiten, der unspezifische Wert einer Hierarchieebene des Objekt-Datensatzes verwendet wird, wenn der Wert der Hierarchieebene nicht als spezifischer Wert hinterlegt ist.

9. Computerprogramm-Element zum Überwachen eines Herstellungsprozesses eines physikalischen Objekts, wobei Objekt-Daten, welche das physikalische Objekt kennzeichnen, verschiedenen Hierarchieebenen zugeordnet sind, wobei Objekt-Daten verschiedener Hierarchieebenen zu hierarchischen Objekt-Datensätzen gruppiert sind, wobei Grenzwerte für mindestens einen Prozessparameter gespeichert und jeweils einem hierarchischen Objekt-Datensatz zugeordnet sind, wobei bei der Herstellung physikalischer Objekte gemessene Prozessdaten des mindestens einen Prozessparameters gespeichert sind und wobei für hergestellte physikalische Objekte die den Objekt-Daten entsprechenden hierarchischen Objekt-Datensätze ermittelt sind, das, wenn es von einem Prozessor ausgeführt wird, folgende Verfahrensschritte aufweist:
Hinterlegen eines unspezifischen Wertes für die Hierarchieebene, wenn für eine Hierarchieebene kein spezifischer Wert im Objekt-Datensatz hinterlegt wird;
Vergleichen von für die entsprechenden Objekt-Datensätze gespeicherten Prozessdaten mit den gespeicherten Grenzwerten für die entsprechenden Objekt-Datensätze;
iteratives Abarbeiten der Hierarchieebenen des Objekt-Datensatzes der gespeicherten Prozessdaten gemäß einer vorgebbaren Hierarchie beim Vergleich, wobei ausgehend von einer höchsten Hierarchieebene solange die nächstniedrigere Hierarchieebene abgearbeitet wird, bis die Abarbeitung die niedrigste Hierarchieebene erreicht hat, und wobei bei dem Abarbeiten, der unspezifische Wert einer Hierarchieebene des Objekt-Datensatzes verwendet wird, wenn der Wert der Hierarchieebene nicht als spezifischer Wert hinterlegt ist.
